(19)

Europäisches
Patentamt

European
Patent Office

Office européen
des brevets

(11)  **EP 4 590 084 A1**

(12)  # EUROPEAN PATENT APPLICATION

(43) Date of publication:
**23.07.2025  Bulletin 2025/30**

(21) Application number: **24189477.3**

(22) Date of filing: **18.07.2024**

(51) International Patent Classification (IPC):
**H10D 12/00** (2025.01)     **H10D 62/10** (2025.01)

(52) Cooperative Patent Classification (CPC):
**H10D 12/481; H10D 62/111**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.01.2024  CN 202410057218**

(71) Applicant: **Suzhou Watech Electronics Co., Ltd.
Suzhou, Jiangsu 215125 (CN)**

(72) Inventors:
- **QI, Jinwei
  Suzhou, 215125 (CN)**
- **LAN, Jinlong
  Suzhou, 215125 (CN)**

(74) Representative: **Michalski Hüttermann & Partner
Patentanwälte mbB
Kaistraße 16A
40221 Düsseldorf (DE)**

(54)  **SJ-IGBT DEVICE WITH N-TYPE TRANSITION LAYER UNDER THE DRIFT REGION**

(57)  The embodiment of the present disclosure provides a SJ-IGBT device including a drift region (7) of the first doping type; a plurality super-junction pillar regions (6) of the second doping type, disposed at intervals in the lateral direction within the drift region; a collector layer (10), a field-stop layer (9) and a transition layer (8-1, 8-2) of the first doping type, between the field-stop layer (9) and the drift region (7); the transition layer being split into two sublayers with different doping concentrations; where the thickness of the overall transition layer is larger than 2 microns and less than or equal to 11 microns, and the doping concentration of the transition layer ranges from larger than or equal to $2.4 \times 10^{14}$/cm$^3$ to less than or equal to $2.4 \times 10^{16}$/cm$^3$, in order to solve the technical problem of a large turn-off energy loss due to the tail current of the conventional SJ-IGBT device in the turn-off stage.

Fig. 2

**EP 4 590 084 A1**

## Description

TECHNICAL FIELD

The present disclosure relates to the technical field of power devices, more particularly to an IGBT device.

BACKGROUND

Insulated Gate Bipolar Transistor (IGBT) is a power semiconductor device that combines the characteristics of metal oxide field effect transistor (MOSFET) and bipolar transistor (BJT). IGBT has an insulated gate structure, which regulates the ability of current to flow through the main current channel by controlling the current at the gate. In IGBT, the electron flows from the N-type material to the P-type material, and the bipolar current conduction mode makes it suitable for high-voltage and high-current applications. By controlling the voltage at the gate, the IGBT can be turned on or off, thereby controlling the flow of current. IGBT is commonly used in power amplification, power conversion, and control applications because of the high input impedance and the controllable conduction capability while being able to handle the high-power current. This makes it an important device in the field of power electronics for driving motors, frequency converters, inverters, and other high-power applications.

Super junction (SJ) is a design structure of power MOSFET and IGBT devices. By forming a series of staggered p-n junctions between n-type and p-type doped layers, higher blocking voltage and lower leakage current are formed, thereby improving the performance of the device. Super junction technology can improve the switching speed, reduce on-resistance, reduce switching loss, increase blocking voltage, reduce leakage current, etc, which is one of the important technologies in high-performance power devices at present.

In recent years, with the further development of technology, the structure and technology of IGBT are getting closer and closer to the theoretical limit. Super junction IGBT with the super junction drift region combines the advantages of FS-IGBT and super junction, can achieve high withstand voltage and low loss, and provides a new direction for further improvement of IGBT performance. Constrained by the conductivity modulation effect of the bipolar device, the space electric field establishment speed of the above-mentioned super junction IGBT is slow during the turn-off process, resulting in a large tail current and a large turn-off energy loss of the device, which is not conducive to the popularization and application of the super junction IGBT. The conventional superjunction IGBT can not meet the high-frequency applications of modern power electronic devices.

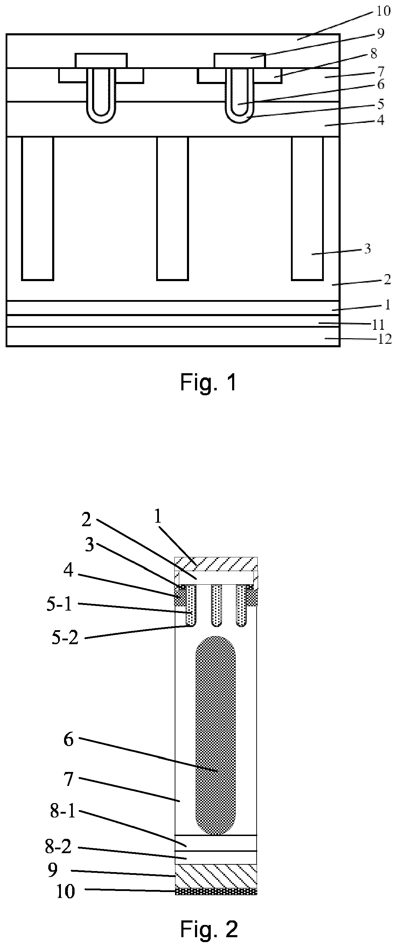

For the conventional SJ-IGBT device, as shown in Fig. 1, 1 is the P- collector region, 2 is the N- drift region, 3 is the P-type super junction region, 4 is the N-type second epitaxy, 5 is the gate oxide layer, 6 is the gate, 7 is the Pwell, 8 is the N+ emitter, 9 is the dielectric layer, 10 is the emitter metal, 11 is the P+ collector, and 12 is the collector metal. For the conventional super junction IGBT devices, a large number of holes will be stored in the part below the P-type super junction region in the N- drift region 2, resulting in the tail current, which leads to a large turn-off loss.

Therefore, the tail current of the conventional SJ-IGBT device in the turn-off stage leads to a large turn-off energy loss, which is a technical problem that needs to be solved urgently by one skilled in the art.

The above-mentioned information disclosed in the background is only for the purpose of enhancing the understanding of the background art of the present disclosure, and therefore it may contain information that has not formed prior art known to one having ordinary skill in the art.

SUMMARY

The embodiment of the present disclosure provides an IGBT device, in order to solve the technical problem of a large turn-off energy loss due to the tail current of the conventional SJ-IGBT device in the turn-off stage.

The embodiment of the present disclosure provides an IGBT device comprising:

a drift region of a first doping type;
a plurality of pillar regions of a second doping type, disposed at intervals in a lateral direction in the drift region;
a transition layer of the first doping type, connected under the pillar region;
where the thickness of the transition layer is larger than 2 microns and less than or equal to 11 microns, and the doping concentration of the transition layer ranges from larger than or equal to $2.4 \times 10^{14}/cm^3$ to less than or equal to $2.4 \times 10^{16}/cm^3$.

The embodiment of the present disclosure also provides an IGBT device comprising:

a drift region of a first doping type;
a plurality of pillar regions of a second doping type, disposed at intervals in a lateral direction in the drift region;

a first transition layer of the first doping type, connected under the pillar region;
a second transition layer of the first doping type, connected under the first transition layer;
where an interface between the first transition layer and the second transition layer is an interface of a depletion region formed in a turn-off stage of the IGBT device;

The thickness and the energy band of the second transition layer satisfy the predetermined relationship, so that excess carriers of the second transition layer are precisely controlled to suppress the tail current generated by the second transition layer.

The embodiments of the present disclosure have the following technical effects with the above technical proposal:

Under the technical idea of precisely controlling the excess carriers of the transition layer, the inventor did a large number of simulations. On the basis of a large number of simulations, combined with theoretical derivation, the thickness requirements for the transition layer are obtained. In a case where the thickness of the transition layer is ranged from larger than 2 microns to less than or equal to 11 microns, and the doping concentration of the transition layer is ranged from larger than or equal to $2.4 \times 10^{14}$/cm$^3$ to less than or equal to $2.4 \times 10^{16}$/cm$^3$, the tail current generated is small, and the turn-off loss is reduced to be minimized.

BRIEF DESCRIPTION OF THE DRAWINGS

The accompanying drawings described herein are used to provide a further understanding of the application and form part of the application, and the illustrative embodiments and explanations of the application are used to explain the application and do not constitute an undue qualification of the application. In the drawings:

Fig. 1 is a structural schematic diagram of a conventional SJ-IGBT device in the background;
Fig. 2 is a structural schematic diagram of an IGBT device according to an embodiment of the present disclosure;
Fig. 3 is a corresponding energy band diagram inside the device in a case where the actual current drops to 10% of the rated current during the turn-off stage of the super junction IGBT device;
Fig. 4 is a simulation diagram of the IGBT device according to the embodiment of the present disclosure and the super junction IGBT device in the background; and
Fig. 5 is a measured diagram of the IGBT device according to the embodiment of the present disclosure and the super junction IGBT device in the background.

REFERENCES IN THE DRAWINGS:

In Background:

1 is the P- collector region, 2 is the N- drift region, 3 is the P-type super junction region, 4 is the N-type second epitaxy, 5 is the gate oxide layer, 6 is the gate, 7 is the Pwell, 8 is the N+ emitter, 9 is the dielectric layer, 10 is the emitter metal, 11 is the P+ collector, and 12 is the collector metal.

In the specific embodiment of the disclosure:

metal emitter 1, isolating oxide layer 2, first doping type region 3, body region 4,
gate 5-1, gate oxide layer 5-2, pillar region 6, drift region 7,
first transition layer 8-1, second transition layer 8-2,
field-stop layer 9, collector 10.

DETAILED DESCRIPTION OF THE EMBODIMENTS

In order to make the technical proposal and advantages of the embodiments of the present disclosure more clear, the following exemplary embodiments of the present disclosure will be described in further detail in conjunction with the accompanying drawings. Obviously, the described embodiments are only a part of the embodiments of the present disclosure, not an exhaustive list of all embodiments. It should be noted that the embodiments and the features of the embodiments of the present disclosure may be combined with each other without conflict.

Embodiment 1

As shown in Fig. 2, an IGBT device according to an embodiment of the present disclosure comprises:

a drift region 7 of a first doping type;

a plurality of pillar regions 6 of a second doping type, disposed at intervals in a lateral direction in the drift region 7;

a transition layer of the first doping type, connected under the pillar region 6;

a field-stop layer 9 of the first doping type, connected under the transition layer;

a collector 10 of the second doping type, connected under the field-stop layer 9;

a deep groove formed downwardly from an upper surface of the drift region 7;

a gate oxide layer 5-2 formed on an inner bottom and side walls of the deep groove;

a gate 5-1 formed in a space enclosed by the gate oxide layer 5-2;

a body region 4 formed on the surrounding of the gate oxide layer 5-2;

a first doping type region 3 formed on the body region 4;

an isolating oxide layer 2 formed on the first doping type region 3, the gate oxide layer 5-2, and the gate 5-1; and

a metal emitter 1 formed on the insulating oxide layer 2.

In the embodiment, the thickness of the transition layer is larger than 2 microns and less than or equal to 11 microns, and the doping concentration of the transition layer is ranged from larger than or equal to $2.4 \times 10^{14}$/cm$^3$ to less than or equal to $2.4 \times 10^{16}$/cm$^3$.

Under the technical idea of precisely controlling the excess carriers of the transition layer, the inventor did a large number of simulations. On the basis of a large number of simulations, combined with theoretical derivation, the thickness requirements for the transition layer are obtained. In a case where the thickness of the transition layer is ranged from larger than 2 microns to less than or equal to 11 microns, and the doping concentration of the transition layer is ranged from larger than or equal to $2.4 \times 10^{14}$/cm$^3$ to less than or equal to $2.4 \times 10^{16}$/cm$^3$, the tail current generated is small, and the turn-off loss is reduced to be minimized.

In the embodiment, as shown in Fig. 2, the transition layer comprises:

a first transition layer 8-1 connected under the pillar region 6, where the thickness of the first transition layer 8-1 ranged from larger than 0 microns and less than or equal to 2 microns, and the doping concentration of the first transition layer 8-1 ranged from larger than or equal to $2.4 \times 10^{14}$/cm$^3$ and less than or equal to $2.4 \times 10^{16}$/cm$^3$; and

a second transition layer 8-2 connected under the first transition layer 8-1, where the thickness of the second transition layer 8-2 ranged from less than or equal to 9 microns, and the doping concentration of the second transition layer 8-2 ranged from larger than or equal to $2.4 \times 10^{14}$/cm$^3$ and less than or equal to $2.4 \times 10^{16}$/cm$^3$.

Specifically, the interface between the first transition layer 8-1 and the second transition layer 8-2 is an interface where the IGBT device forms a depletion region in the turn-off stage, and the depletion region is located in the first transition layer 8-1 and does not enter the second transition layer 8-2. In this way, in the turn-off stage of the IGBT device, the edge of the formed depletion region is the interface between the first transition layer 8-1 and the second transition layer 8-2, and the carriers of the first transition layer 8-1 are depleted.

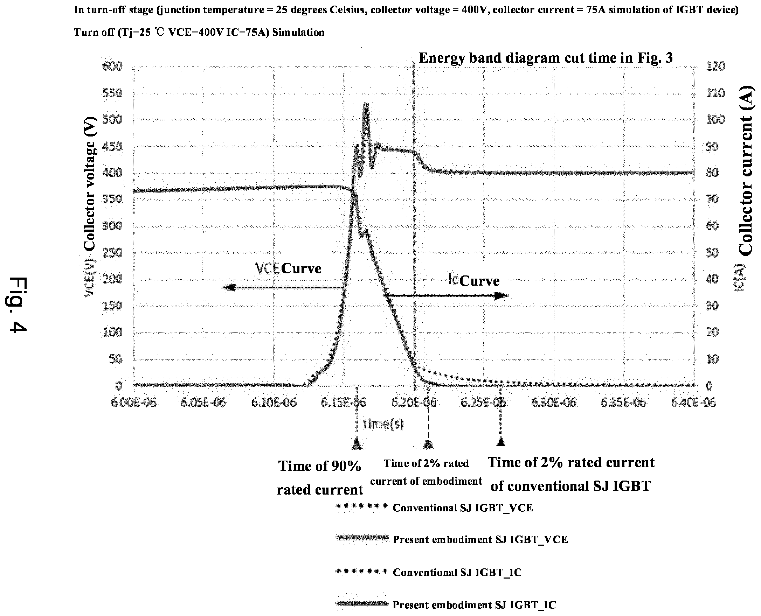

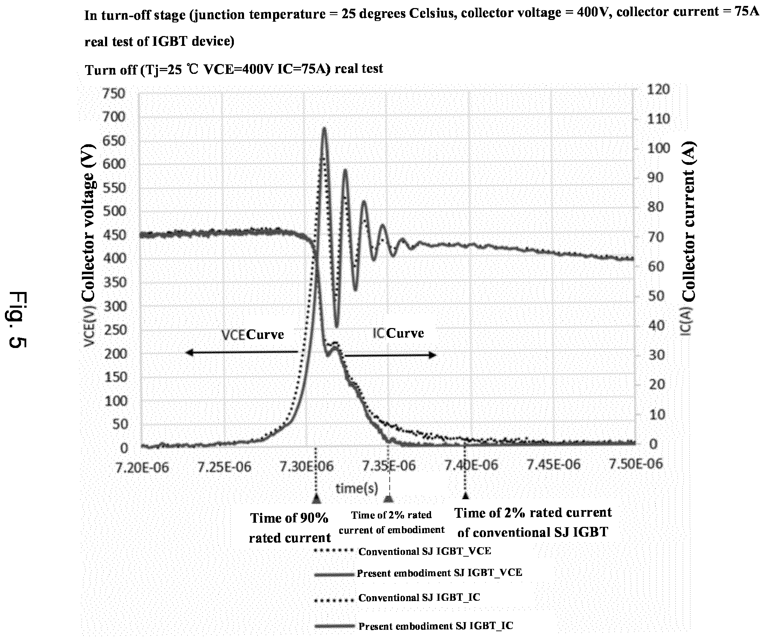

Under the technical idea of precisely controlling the excess carriers of the second transition layer 8-2, the inventor did a large number of simulations. On the basis of a large number of simulations, combined with theoretical derivation, the thickness requirements for the second transition layer 8-2 are obtained. The excess carriers of the second transition layer 8-2 with a thickness of less than or equal to 9 microns generate a small tail current, which minimizes the turn-off loss. The simulation and measurement results are shown in Figs. 4 and 5.

The thickness and the energy band of the second transition layer 8-2 satisfy the predetermined relationship, so that excess carriers of the second transition layer 8-2 are precisely controlled to suppress the tail current generated by the second transition layer 8-2.

The thickness and the energy band of the second transition layer 8-2 satisfy the predetermined relationship, so as to precisely control the excess carriers of the second transition layer 8-2 to suppress the tail current generated by the second transition layer 8-2.

In the embodiment, the excess carriers of the second transition layer 8-2 need to satisfy the following requirements:

In the turn-off stage of the IGBT device, when the actual current of the IGBT device drops to a first predetermined current ratio of the rated current of the IGBT device, the concentration P of holes per unit volume of the second transition layer 8-2 satisfies the following first predetermined relationship:

$P \le n_i$ defined as the first predetermined relationship;

where $n_i$ is the intrinsic carrier concentration of the silicon material and the first predetermined current ratio is ranged from larger than or equal to 10% and less than or equal to 20%.

Under the technical idea of precisely controlling the excess carriers of the second transition layer 8-2, the inventor did a large number of simulations. On the basis of a large number of simulations, combined with theoretical derivation, the first predetermined relationship is obtained. It is found that if the second transition layer 8-2 satisfies the first predetermined relationship, the tail current generated by excess carriers is small, which minimizes the turn-off loss. The simulation and measurement results are shown in Figs. 4 and 5.

In the embodiment, the value of the first predetermined current ratio of the finished IGBT device is equal to the value of the second predetermined current ratio of the design-fundamental IGBT device.

The finished IGBT device is the IGBT device in which the excess carriers of the second transition layer 8-2 are precisely controlled, that is, the IGBT device of the present disclosure. The structure of the design-fundamental IGBT device is the same as the structure of the finished IGBT device but the excess carriers of the second transition layer 8-2 are not controlled.

Determining the value of the second predetermined current ratio of the design-fundamental IGBT device is as follows:

> Step S1: In the simulation process of the design-fundamental IGBT device, initially assigning value to the second predetermined current ratio;
> Step S2: Determining a time when the actual current dropped to the assigned second predetermined current ratio of the rated current of the design-fundamental IGBT device, and the time divide the turn-off stage into a front turn-off stage and a rear turn-off stage; and
> Step S3: Determining whether the ratio of the turn-off loss of the rear turn-off stage to the turn-off loss of the entire turn-off stage is within a predetermined control range:
> if within the predetermined control range, the value assigned at this time is the value of the second predetermined current ratio of the design-fundamental IGBT device;
> if not within the predetermined control range, jumping to Step S1 again to continue to execute steps S1 and S2 until a value assigned as the second predetermined current ratio of the design-fundamental IGBT device is found.

In this way, the second predetermined current ratio of the design-fundamental IGBT device is assigned several times by simulation, and the method is continuously approaching until the value assigned as the second predetermined current ratio of the design-fundamental IGBT device is found. Thus, the first predetermined current ratio of the finished IGBT device is obtained.

In the embodiment, in the design-fundamental IGBT device (the IGBT device with the same structure without precise control of the excess carriers of the second transition layer 8-2), the predetermined control range is larger than or equal to 20% and less than or equal to 50%.

According to the simulation results, the predetermined control range is larger than or equal to 20% and less than or equal to 50%. According to the simulation results, when the predetermined control range is larger than or equal to 20% and less than or equal to 50%, the tail current is very small, and the turn-off loss in the turn-off stage is small.

In the embodiment, in the turn-off stage of the IGBT device, when the actual current of the IGBT device drops to the predetermined current ratio of the rated current of the IGBT device, according to the first predetermined relationship, the thickness $H_2$ and energy band of the second transition layer 8-2 satisfies the following second predetermined relationship:

$$H_2 \leq 1/e^{\frac{\frac{E_g}{2} - (E_{Fp} - E_V)}{kT}}$$

defined as the second predetermined relationship;
where $H_2$ is a thickness of the second transition layer 8-2, e is a natural unit of charge and is a constant, k is a Boltzmann constant, T is a temperature, $E_g$ is a band gap width of the Si material and $E_g$ = 1.12eV at ambient temperature, $E_{Fp}$ is a hole quasi-Fermi level and here a hole quasi-Fermi level of the silicon material, and $E_V$ is a valence band level and here a valence band level of the silicon material.

In the embodiment, when T = 300K, kT = 0.026eV, $E_g$ = 1.12eV, the second predetermined relationship is simplified to a third predetermined relationship:

$$H_2 \leq 1/e^{\frac{0.56 - (E_{Fp} - E_V)}{0.026}}$$

defined as the third predetermined relationship;
wherein the value $E_{Fp}$ - $E_V$ in the third predetermined relation is taken as the average value of $E_{Fp}$ - $E_V$ at each thickness position of the second transition layer 8-2.

In the embodiment, when the average value of $E_{Fp}$ - $E_V$ at each thickness position of the second transition layer 8-2 is 0.258eV and 0.258eV is brought into the third predetermined relationship, the value range of the second transition layer 8-2 is less than or equal to 9 microns.

The inventors did several simulations on the IGBT devices of the present disclosure of various powers, and when the average value of $E_{Fp}$ - $E_V$ at each thickness position of the second transition layer 8-2 is 0.258eV, the IGBT devices of various powers do not generate significant tail current. Therefore, for the IGBT device having the drift region 7, the pillar region 6, the first transition layer 8-1, and the second transition layer 8-2, when the average value of $E_{Fp}$ - $E_V$ at each thickness position of the second transition layer 8-2 is 0.258eV, the thickness range of the second transition layer 8-2 is less than or equal to 9 microns, which is a fairly universal feature.

In the embodiment, the second transition layer 8-2 is evenly doped, and the doping concentration range of the second transition layer 8-2 is larger than or equal to $2.4 \times 10^{14}/cm^3$ and less than or equal to $2.4 \times 10^{16}/cm^3$.

The doping concentration range of the second transition layer 8-2 can ensure the voltage withstand capability of the device.

In the embodiment, the doping concentrations of the drift region 7, the first transition layer 8-1, and the second transition layer 8-2 are increased sequentially.

The optimal performance is achieved, ensuring that the depletion region is completely stopped in the first transition layer 8-1 when the device operates, and the thickness of the second transition layer 8-2 is easy to design.

The IGBT device in which the first doping type is N-type doping and the second doping type is P-type doping will be described below.

The IGBT device according to the embodiment of the present disclosure achieves lower losses than conventional super junction IGBTs by optimizing the thicknesses of the first transition layer 8-1 and the second transition layer 8-2 and the thickness and concentration of the field-stop layer 9.

In order to obtain adaptable thicknesses of the first transition layer 8-1 and the second transition layer 8-2 and the thickness and concentration of the field-stop layer 9, the design process of the IGBT device according to the embodiment of the present disclosure is as follows:

For high-voltage and high-power super junction IGBT devices, the current trailing in the turn-off stage (in the turn-off stage, the actual current of the IGBT device is dropping) is the key to the performance of the device, which directly affects the value of the turn-off loss. The invention focuses on solving the trailing of the current in the turn-off stage of the Super Junction IGBT.

The IGBT device enters the current tailing stage, the first transition layer 8-1 to the collector direction, the energy level of the conduction band (Ec), electron quasi-Fermi level ($E_{Fn}$), hole quasi-Fermi level ($E_{Fp}$), and valence band (Ev) in the device are increased rapidly, and a high carrier barrier appears inside the device, resulting in the carrier in the bottom region of the chip cannot freely enter the space electric field region, and most of the non-equilibrium carriers in this region can only disappear through recombination, resulting in a long-term tail current.

In order to more accurately design the thicknesses and concentrations of the first transition layer 8-1, the second transition layer 8-2, and the field-stop layer 9, the disclosure provides to speed up the design of the optimal SJ IGBT structure from the energy band perspective.

The design-fundamental IGBT device of the present disclosure is an IGBT device of which layer structure is consistent with the present disclosure, and the thickness of the second transition layer 8-2 is relatively large (that is, the excess carriers of the second transition layer 8-2 are not precisely controlled) to have simulation and theoretical calculation.

Firstly, the turn-off stage of the superjunction design-fundamental IGBT device is analyzed according to band theory. In the turn-off stage, the actual current of the design-fundamental IGBT device continues to drop.

Step S1-1: Initially assigning value to the second predetermined current ratio of the design-fundamental IGBT device, such as the initial value assigned is 10%;

Step S2-1: Determining a time when the actual current dropped to the predetermined current ratio (i.e. 10%) of the rated current of the design-fundamental IGBT device, and the time divide the turn-off stage into a front turn-off stage and a rear turn-off stage; and

Step S3-1: Determining the ratio of the turn-off loss of the rear turn-off stage to the turn-off loss of the entire turn-off stage:

if the ratio is within the predetermined control range, the value assigned at this time is the value of the second predetermined current ratio of the rated current which the actual current of the design-fundamental IGBT device dropped to; and

if the ratio is not within the predetermined control range, re-jumping to step S1-1, until the assigned value as the second predetermined current ratio of the rated current which the actual current of the design-fundamental IGBT device dropped to is found.

In this way, the second predetermined current ratio of the design-fundamental IGBT device is assigned several times by simulation, and the method is continuously approaching until the value assigned as the second predetermined current ratio of the design-fundamental IGBT device is found. Thus, the first predetermined current ratio of the finished IGBT device is obtained.

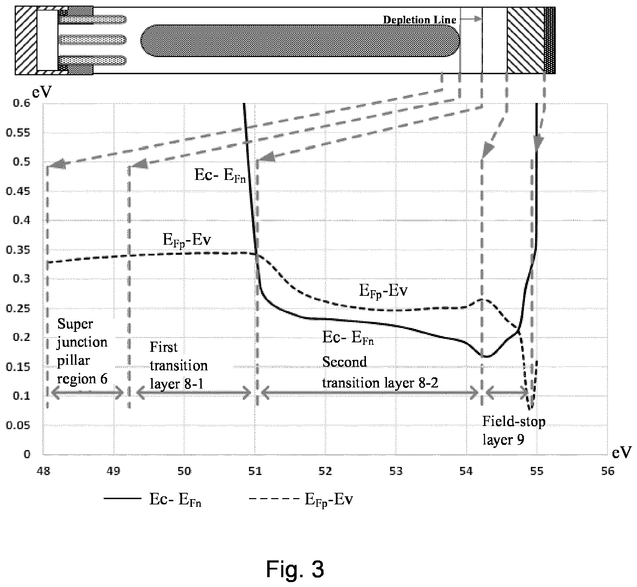

At the moment when the actual current of the IGBT device drops to 10% of the rated current, the turn-off loss generated after this moment greatly increases the turn-off loss of the device (for example, the ratio of the turn-off loss in the rear turn-off stage to the turn-off loss in the entire turn-off stage reaches 30%, that is, the predetermined control range is larger than or equal to 20% and less than or equal to 50%), that is, 10% can be defined as the predetermined current ratio A% of the rated current of the IGBT device which the actual current of the IGBT device dropped to. At this time, the distribution of non-equilibrium carriers in the first transition layer 8-1, the second transition layer 8-2, and the field-stop layer 9 is shown in Fig. 3.

At present, in the turned-off stage of most IGBT devices, when the actual current drops to 10% of the rated current, the voltages at two terminals are already the bus voltage, and the depletion region has been formed. Therefore, the interface between the first transition layer 8-1 and the second transition layer 8-2 is formed, and the interface does not change subsequently. The present disclosure provides the technical concept of, in the turned-off stage of the IGBT device and after the depletion region has been formed, forming the first transition layer 8-1 and the second transition layer 8-2 and precisely controlling the excess carriers of the second transition layer 8-2, thereby reducing the tail current.

Fig. 3 is an energy band diagram inside the device in a case where the actual current drops to 10% of the rated current during the turn-off stage of the super junction IGBT device. The unit of the horizontal and vertical axes is eV, the black solid curve is $Ec-E_{Fn}$, and the black dashed curve is $E_{Fp} - Ev$.

As shown in Fig. 3, at the time when the actual current of the IGBT device drops to 10% of the rated current during the turn-off stage of the IGBT device, the device can be divided into four regions according to the energy band characteristics at different positions inside the device:

the super junction pillar region 6, the first transition layer 8-1 (depletion region), the second transition layer 8-2, and the field-stop layer 9.

When the actual current of the IGBT device drops to 10% of the rated current, the energy bands in the four regions are analyzed as follows:

The distance $(Ec-E_{Fn})$ from the conduction band (Ec) to the quasi-Fermi level $(E_{Fn})$ directly reflects the electron concentration at the corresponding position, and the electron concentration increases exponentially with the decrease of $(Ec-E_{Fn})$.

Correspondingly, the distance $(E_{Fp} -Ev)$ from the valence band (Ev) to the quasi-Fermi level $(E_{Fp})$ directly reflects the hole concentration, and the hole concentration increases exponentially with the decrease of $(E_{Fn}-Ev)$.

The super junction pillar region 6: since $(Ec-E_{Fn})$ is higher than 0.6eV (corresponding to $Ec-E_{Fn} > 0.6eV$), there are almost no electrons in this region.

Correspondingly, $(E_{Fp}-Ev)$ is between 0.35eV and 0.4eV (corresponding to $0.35eV < E_{Fp}-E_v < 0.4eV$), so there is a certain amount of conductive holes in this region. The super junction pillar region is a region where the drift region (7) coincides with the pillar region 6 of the second doping type. The above-mentioned band characteristics indicate that the conductive carriers in the super junction pillar region 6 are mainly holes. The holes in this region are mainly introduced by the drift of the space electric field in the first transition layer 8-1.

The first transition layer 8-1 (depletion region): $(Ec-E_{Fn})$ rapidly increases from 0.375eV and exceeds 0.6eV. Obviously, there are only a few electrons in this region at the critical position with the second transition layer 8-2, and there are no conductive electrons in the remaining positions.

The $(E_{Fp} -Ev)$ characteristics of this region are similar to the super junction pillar region 6, and $(E_{Fp} -Ev)$ is between 0.35eV and 0.4eV (corresponding to $0.35eV < E_{Fp}-E_V < 0.4eV$), then there is a certain amount of conductive holes in this region. That is, the first transition layer 8-1 also has a large number of holes, and a hole current is generated. The holes in this region are mainly introduced by the diffusion of the second transition region 8-2.

The second transition layer 8-2: Both $(Ec-E_{Fn})$ and $(E_{Fp}-Ev)$ in this region are less than 0.375eV, indicating that there are conductive electrons and holes in this region at the same time, and form an on-current (manifested as a tail current during IGBT turning-off).

As the depth from the back of the chip increases, $(Ec-E_{Fn})$ shows a monotonous increasing trend, that is, the electron concentration decreases exponentially.

On the contrary, $(E_{Fp}-Ev)$ shows a nonlinear trend of decreasing firstly and then increasing, that is, there is a hole-rich region in the middle of the region. The duration of the IGBT tail current depends on the total number of holes in the hole-rich region. Obviously, optimizing the hole distribution morphology in this region can fundamentally improve the problem of IGBT current trailing.

The field-stop layer 9: Both $(Ec-E_{Fn})$ and $(E_{Fp}-Ev)$ in this region are less than 0.375eV, indicating that there are conducting electrons and holes in this region at the same time, generating electron currents and hole currents respectively.

As the depth from the back of the chip increases, $(Ec-E_{Fn})$ shows a monotonous decreasing trend, that is, the electron concentration increases exponentially.

On the contrary, ($E_{Fp}$-Ev) shows a monotonic decreasing trend, that is, the hole concentration decreases exponentially. The above characteristics indicate that the hole concentration within the field-stop layer 9 decreases rapidly with increasing depth.

Thus, the non-equilibrium carriers in the first transition layer 8-1, the second transition layer 8-2, and the field-stop layer 9 are the fundamental problem of current tailing. In order to effectively reduce the tailing current, the device structure can be designed and optimized by controlling the total amount of non-equilibrium carriers to reduce the total amount of excess carriers. In the present disclosure, under the premise of maintaining the pressure-bearing capacity of the device, the thickness of the first transition layer 8-1 and the second transition layer 8-2 under the pillar region, the thickness and concentration of the field-stop layer 9 are designed to obtain the optimal turn-off characteristics, that is, small current trailing.

So far, the IGBT device whose thickness of the second transition layer 8-2 is relatively large (that is, the excess carriers of the second transition layer 8-2 are not precisely controlled) has a relatively large tail current. Therefore, it is necessary to control the excess carriers (i.e., holes) of the second transition layer 8-2. How to control and the method of control are important contents of the disclosure, as follows:

The total amount of non-equilibrium carriers (i.e. excess carriers) in the second transition layer 8-2 is theoretically analyzed, and the relationship between the thickness $H_2$ and the energy band of the second transition layer 8-2 is obtained.

The process is as follows:

Based on the theory of semiconductor physics, the carrier concentration per unit volume p and the energy band satisfy the following number order relationship:

$$p = n_i \times e^{\frac{E_i - E_F}{kT}}$$
$$\text{Formula 1;}$$

where Formula 1 is not only applicable to hole carriers, but also applicable to electron carriers; p is the carrier concentration per volume, $n_i$ is the intrinsic carrier concentration, e is the natural unit of charge, K is the Boltzmann constant ($1.38 \times 10^{-23}$ J/K), T is the temperature, $E_i$ is the midline level of the band gap, and $E_F$ is the Fermi level. Intrinsic carrier concentration $n_i$ is the equilibrium concentration of free electrons and free holes in intrinsic semiconductor materials. The common value of $n_i$ is the concentration value at 300K. When T = 300K, the recognized value of the intrinsic carrier concentration $n_i$ of silicon is $1.5 \times 10^{10}$/cm$^3$.

Since it can be seen from Fig. 3 that there is a hole-rice region in the middle of the second transition layer 8-2, that is, the excess carriers of the second transition layer 8-2 should be holes. When the thickness of the second transition layer 8-2 is expressed by $H_2$, the concentration P of holes per unit volume of the second transition layer 8-2 satisfies Formula 2:

$$P = H_2 \times n_i \times e^{\frac{E_i - E_F}{kT}}$$
$$\text{Formula 2.}$$

In order to effectively control the number of excess carriers in the second transition layer 8-2, in the structure of the IGBT device design according to the embodiment of the present disclosure, the excess carriers in the second transition layer 8-2 are hole carriers, and the concentration P per unit volume of holes in the second transition layer 8-2 further satisfies Formula 3:

$$P \leq n_i$$
$$\text{Formula 3.}$$

The essence of Formula 3 is to control the number of holes in the second transition layer 8-2. Formula 3 is employed as the first predetermined relationship.

Under the technical idea of precisely controlling the excess carriers of the second transition layer 8-2, the inventor did a large number of simulations. On the basis of a large number of simulations, combined with theoretical derivation, the first predetermined relationship is obtained. It is found that if the second transition layer 8-2 satisfies the first predetermined relationship, the tail current generated by excess carriers is small, which minimizes the turn-off loss. The simulation and measurement results are shown in Figs. 4 and 5.

For hole carriers, ($E_i$ - $E_F$) and the band gap satisfies Formula 4:

$$E_i - E_F = \frac{E_g}{2} - (E_{Fp} - E_V)$$

Formula 4;

where $E_g$ is the band gap of Si material and $E_g$ = 1.12 eV at ambient temperature (T = 300K), $E_{Fp}$ is the hole quasi-Fermi level, $E_{Fn}$ is electron quasi-Fermi level, Ev is the valence band level and here is the valence band energy level of silicon material.

Bring Formula 4 into Formula 3,

$$H_2 \times n_i \times e^{\frac{\frac{E_g}{2}-(E_{Fp}-E_V)}{kT}} \leq n_i$$

can be obtained, further to simplify to obtain Formula 5:

$$H_2 \times e^{\frac{\frac{E_g}{2}-(E_{Fp}-E_V)}{kT}} \leq 1$$

Formula 5.

That is, the thickness $H_2$ of the second transition layer 8-2 is related to the energy band.

Further derivation, it is concluded that:

$$H_2 \leq 1/e^{\frac{\frac{E_g}{2}-(E_{Fp}-E_V)}{kT}}$$

defined as the second predetermined relationship.

In the second predetermined relation, at ambient temperature (T = 300 K), $E_g$ = 1.12eV, the electron energy is expressed as kT to be 0.026eV, that is, kT = 0.026eV, and brought into the second predetermined relationship to obtain the third predetermined relationship;

$$H_2 \leq 1/e^{\frac{\frac{E_g}{2}-(E_{Fp}-E_V)}{kT}}$$

defined as the third predetermined relationship.

Thus, according to the theoretical analysis, a third predetermined relationship for the thickness $H_2$ of the second transition layer 8-2 is obtained.

So far, the third predetermined relationship shows the predetermined relation satisfied by the thickness and energy band of the second transition layer 8-2. The turn-off loss of the IGBT device according to the embodiment of the present disclosure (having the second transition layer 8-2 satisfying the third predetermined relationship) for the entire turn-off stage corresponds only to the (1 - predetermined control range B%) of turn-off loss of the entire turn-off stage of the design-fundamental IGBT device.

In the third predetermined relationship, the value of $E_{Fp}$ - $E_V$ at each thickness position of the second transition layer 8-2 is different, that is, the value of $E_{Fp}$-$E_V$ in the second transition region is variable.

Overall, the value of $E_{Fp}$ - $E_V$ in the third predetermined relationship is the average value of $E_{Fp}$ - $E_V$ at each thickness position of the second transition layer 8-2.

Combining the above theoretical analysis with the simulation verification results, when the average value of each thickness position of the second transition layer 8-2 is 0.258eV, and 0.258eV is brought into the third predetermined relationship,

and the value range of the second transition layer 8-2 is obtained to be less than or equal to 9 microns.

It is obtained by simulation that when the average value of $E_{Fp}$ - $E_V$ at each thickness position of the second transition layer 8-2 is 0.258eV, the excess holes of the second transition layer 8-2 do not cause a significant tail current.

The inventors did several simulations on the IGBT devices of the present disclosure of various powers, and when the average value of $E_{Fp}$ - $E_V$ at each thickness position of the second transition layer 8-2 is 0.258eV, the IGBT devices of various powers do not generate significant tail current. Therefore, for the IGBT device having the drift region 7, the pillar region 6, the first transition layer 8-1, and the second transition layer 8-2, when the average value of $E_{Fp}$ - $E_V$ at each thickness position of the second transition layer 8-2 is 0.258eV, the thickness range of the second transition layer 8-2 is less than or equal to 9 microns, which is a fairly universal feature.

The first transition layer 8-1 will be described below.

As the doping of the first transition layer 8-1 is evenly doped, the thickness $H_1$ of the first transition layer 8-1 ranges from larger than 0 microns and less than or equal to 2 microns.

In the embodiment, when the doping of the first transition layer 8-1 is evenly doped, under the condition that the thickness $H_1$ of the first transition layer 8-1 is ranged from larger than 0 microns and less than or equal to 2 microns, the following requirements need to be satisfied:

The doping concentration $N_D$ of the first transition layer 8-1 and the thickness $H_1$ of the first transition layer 8-1 satisfy the following relationship:

$$n\% \times k\% \times BV = Em \times H_1 - q \times N_D \times H_1^2/2\varepsilon s;$$

$$Em = k\% \times Ec;$$

where k% is the percentage of the electric field intensity to the critical breakdown electric field intensity under the condition of the minimum predetermined working voltage of the IGBT device, and the value of the percentage of the minimum predetermined working voltage to the breakdown voltage is the value of k%; n% is the percentage of the voltage bore by the first transition layer 8-1 to the minimum predetermined operating voltage, the value range of n% is larger than 0% but less than or equal to 5%, Em is the maximum field strength corresponding to the minimum predetermined operating voltage of the IGBT device, Ec is 0.25Mv/cm, q is the charge of a single electron, and εs is the dielectric constant of the Si substrate of the IGBT device.

The first transition layer 8-1 satisfies the above requirements. The interface between the first transition layer 8-1 and the second transition layer 8-2 is an interface where the IGBT device forms the depletion region during the turn-off stage. The depletion region is located in the first transition layer 8-1 and does not enter the second transition layer 8-2.

Specifically, when the value of n% is 5%, the value of k% is 10%, and the above formula corresponds to:

$$5\% \times 10\% \times BV = Em \times H_1 - q \times N_D \times H_1^2/2\varepsilon s;$$

$$Em = 10\% \times Ec;$$

where k% is the percentage of the electric field intensity to the critical breakdown electric field intensity under the condition of the minimum predetermined working voltage of the IGBT device, n% is the percentage of the voltage borne by the first transition layer 8-1 to the minimum predetermined working voltage, n% is larger than 0% but less than or equal to 5%, Em is the maximum field strength corresponding to the minimum predetermined working voltage of the IGBT device, Ec is 0.25Mv/cm, q is the charge amount of a single electron, and εs is the dielectric constant of Si.

$5\% \times 10\% \times BV$ on the left side of the formula, that is, the voltage value that the first transition layer 8-1 can withstand. For example, the breakdown voltage target of the IGBT device design is 1200 volts, and the minimum predetermined operating voltage is 10% × BV, that is, the super junction structure formed by the drift region and the pillar region undertakes 95% of the minimum predetermined operating voltage. Then, the electric field first transition layer 8-1 bears 5% of the minimum predetermined operating voltage, and the actual voltage value borne by the first transition layer 8-1 varies with the thickness and the doping concentration of the first transition layer 8-1.

The field-stop layer of the IGBT device is described below.

In the embodiment, the doping concentration of the field-stop layer 9 is less than the doping concentration of the first transition layer 8-1 and the second transition layer 8-2.

The thickness of the field-stop layer 9 is larger than or equal to 1 micron and less than or equal to 3 microns, and the doping concentration of the field-stop layer 9 is larger than or equal to $2\times10^{15}/cm^3$ and less than or equal to

$2\times10^{17}/cm^3$.

In the embodiment, the doping concentrations of the drift region 7, the first transition layer 8-1, and the second transition layer 8-2 are increased sequentially.

The SJ IGBT of the present disclosure analyzes in detail the distribution rule of non-equilibrium carriers in the transition region and the N+ field cutoff region of the SJ IGBT turning-off trailing stage from the energy band theory, so as to design an SJ IGBT device with a low tail current (an IGBT device with junction temperature = 25 degrees Celsius and collector voltage = 400V and collector current = 75 amperes in the operation of the SJ IGBT device). Fig. 4 shows the simulation result of the SJ IGBT device in the turn-off stage. As shown in Fig. 4, the horizontal axis is time in seconds (s), the left vertical axis is the collector voltage (VCE) at operation in volts (V), and the right vertical axis is the collector current (IC) in amperes (A). As shown in Fig. 4, it can be seen from the simulation results that the current tailing of the optimized structure Super Junction IGBT has been significantly improved, and the current drop time is reduced from 100ns to 46ns (the time it takes for the IC to drop from 90% of the rated current to 2% of the rated current), correspondingly, the turn-off loss

$$\text{Eoff} = \int_0^{\Delta t} \text{VCE}(t) \times \text{IC}(t) dt$$

( (where $\triangle t$ is the current drop time) is reduced by 0.12mJ (1.08mJ is reduced to 0.96mJ).

SJ IGBT device with low tail current (IGBT device with junction temperature = 25 degrees Celsius, collector voltage = 400V, collector current = 75A when operating), Fig. 5 shows the measured results of the SJ IGBT device in the turn-off stage. As shown in Fig. 5, the horizontal axis is time in seconds (s), the left vertical axis is the collector voltage (VCE) at operation in volts (V), and the right vertical axis is the collector current (IC) in amperes (A). As shown in Fig. 5, the actual test current tailing of the optimized structure Super Junction IGBT is shortened from 92ns to 43ns (the time it takes for the IC to drop from 90% of the rated current to 2% of the rated current), and the corresponding turn-off loss (

$$\text{Eoff} = \int_0^{\Delta t} \text{VCE}(t) \times \text{IC}(t) dt$$

(where $\triangle t$ is the current drop time) is reduced by 0.21mJ (0.91mJ is reduced to 0.70mJ), the performance is improved by 23%, and the turn-off performance of Super Junction IGBT has been significantly improved.

Embodiment 2

As shown in Fig. 2, an IGBT device according to an embodiment of the present disclosure comprises:

a drift region 7 of a first doping type;
a plurality of pillar regions 6 of a second doping type, disposed at intervals in a lateral direction in the drift region 7;
a first transition layer 8-1 of the first doping type, connected under the pillar region 6;
a second transition layer 8-2 of the first doping type, connected under the first transition layer 8-1;
a field-stop layer 9 of the first doping type, connected under the second transition layer 8-2;
a collector 10 of the second doping type, connected under the field-stop layer 9;
a deep groove formed downwardly from an upper surface of the drift region 7;
a gate oxide layer 5-2 formed on an inner bottom and side walls of the deep groove;
a gate 5-1 formed in a space enclosed by the gate oxide layer 5-2;
a body region 4 formed on the surrounding of the gate oxide layer 5-2;
a first doping type region 3 formed on the body region 4;
an isolating oxide layer 2 formed on the first doping type region 3, the gate oxide layer 5-2, and the gate 5-1; and
a metal emitter 1 formed on the insulating oxide layer 2.

In the embodiment, the interface between the first transition layer 8-1 and the second transition layer 8-2 is an interface where the IGBT device forms a depletion region in the turn-off stage, and the depletion region is located in the first transition layer 8-1 and does not enter the second transition layer 8-2. In this way, in the turn-off stage of the IGBT device, the edge of the formed depletion region is the interface between the first transition layer 8-1 and the second transition layer 8-2, and the carriers of the first transition layer 8-1 are depleted.

The thickness and the energy band of the second transition layer 8-2 satisfy the predetermined relationship, so that excess carriers of the second transition layer 8-2 are precisely controlled to suppress the tail current generated by the second transition layer 8-2.

Under the technical idea of precisely controlling the excess carriers of the second transition layer 8-2, the inventor did a large number of simulations. On the basis of a large number of simulations, combined with theoretical derivation, the thickness requirements for the second transition layer 8-2 are obtained. The excess carriers of the second transition layer 8-2 with a thickness of less than or equal to 9 microns generate a small tail current, which minimizes the turn-off loss. The simulation and measurement results are shown in Figs. 4 and 5.

The thickness and the energy band of the second transition layer 8-2 satisfy the predetermined relationship, so that excess carriers of the second transition layer 8-2 are precisely controlled to suppress the tail current generated by the second transition layer 8-2.

The thickness and the energy band of the second transition layer 8-2 satisfy the predetermined relationship, so as to precisely control the excess carriers of the second transition layer 8-2 to suppress the tail current generated by the second transition layer 8-2.

In the embodiment, the excess carriers of the second transition layer 8-2 need to satisfy the following requirements:

In the turn-off stage of the IGBT device, when the actual current of the IGBT device drops to a first predetermined current ratio of the rated current of the IGBT device, the concentration P of holes per unit volume of the second transition layer 8-2 satisfies the following first predetermined relationship:

$P \leq n_i$ defined as the first predetermined relationship;
where $n_i$ is the intrinsic carrier concentration of the silicon material and the first predetermined current ratio is ranged from larger than or equal to 10% and less than or equal to 20%.

Under the technical idea of precisely controlling the excess carriers of the second transition layer 8-2, the inventor did a large number of simulations. On the basis of a large number of simulations, combined with theoretical derivation, the first predetermined relationship is obtained. It is found that if the second transition layer 8-2 satisfies the first predetermined relationship, the tail current generated by excess carriers is small, which minimizes the turn-off loss. The simulation and measurement results are shown in Figs. 4 and 5.

In the embodiment, the value of the first predetermined current ratio of the finished IGBT device is equal to the value of the second predetermined current ratio of the design-fundamental IGBT device.

The finished IGBT device is the IGBT device in which the excess carriers of the second transition layer 8-2 are precisely controlled, that is, the IGBT device of the present disclosure. The structure of the design-fundamental IGBT device is the same as the structure of the finished IGBT device but the excess carriers of the second transition layer 8-2 are not controlled.

Determining the value of the second predetermined current ratio of the design-fundamental IGBT device is as follows:

Step S1: In the simulation process of the design-fundamental IGBT device, initially assigning value to the second predetermined current ratio;

Step S2: Determining a time when the actual current dropped to the assigned second predetermined current ratio of the rated current of the design-fundamental IGBT device, and the time divide the turn-off stage into a front turn-off stage and a rear turn-off stage; and

Step S3: Determining whether the ratio of the turn-off loss of the rear turn-off stage to the turn-off loss of the entire turn-off stage is within a predetermined control range:

if within the predetermined control range, the value assigned at this time is the value of the second predetermined current ratio of the design-fundamental IGBT device;

if not within the predetermined control range, jumping to Step S1 again to continue to execute steps S1 and S2, until the assigned value as the second predetermined current ratio of the design-fundamental IGBT device is found.

In this way, the second predetermined current ratio of the design-fundamental IGBT device is assigned several times by simulation, and the method is continuously approaching until the value assigned as the second predetermined current ratio of the design-fundamental IGBT device is found. Thus, the first predetermined current ratio of the finished IGBT device is obtained.

In the embodiment, in the design-fundamental (an IGBT device with the same structure without precise control of the excess carriers of the second transition layer 8-2), the predetermined control range is larger than or equal to 20% and less than or equal to 50%.

According to the simulation results, the predetermined control range is larger than or equal to 20% and less than or equal to 50%. According to the simulation results, when the predetermined control range is larger than or equal to 20% and less than or equal to 50%, the tail current is very small, and the turn-off loss in the turn-off is small.

In the embodiment, in the turn-off stage of the IGBT device, when the actual current of the IGBT device drops to the predetermined current ratio of the rated current of the IGBT device, according to the first predetermined relationship, the thickness $H_2$ and energy band of the second transition layer 8-2 satisfies the following second predetermined relationship:

$$H_2 \leq 1/e^{\frac{\frac{E_g}{2} - (E_{Fp} - E_V)}{kT}}$$

defined as the second predetermined relationship;

where $H_2$ is a thickness of the second transition layer 8-2, e is a natural unit of charge and is a constant, k is a Boltzmann constant, T is a temperature, $E_g$ is a band gap width of the Si material and $E_g$ = 1.12eV at ambient temperature, $E_{Fp}$ is a hole quasi-Fermi level and here a hole quasi-Fermi level of the silicon material, and $E_V$ is a valence band level and here a valence band level of the silicon material.

In the embodiment, when T = 300K, kT = 0.026eV, $E_g$ = 1.12eV, the second predetermined relationship is simplified to a third predetermined relationship:

$$H_2 \leq 1/e^{\frac{0.56 - (E_{Fp} - E_V)}{0.026}}$$

defined as the third predetermined relationship;

wherein the value $E_{Fp}$ - $E_V$ in the third predetermined relation is taken as the average value of $E_{Fp}$ - $E_V$ at each thickness position of the second transition layer 8-2.

In the embodiment, when the average value of $E_{Fp}$ - $E_V$ at each thickness position of the second transition layer 8-2 is 0.258eV and 0.258eV is brought into the third predetermined relationship, the value range of the second transition layer 8-2 is less than or equal to 9 microns.

The inventors did several simulations on the IGBT devices of the present disclosure of various powers, and when the average value of $E_{Fp}$ - $E_V$ at each thickness position of the second transition layer 8-2 is 0.258eV, the IGBT devices of various powers do not generate significant tail current. Therefore, for the IGBT device having the drift region 7, the pillar region 6, the first transition layer 8-1, and the second transition layer 8-2, when the average value of $E_{Fp}$ - $E_V$ at each thickness position of the second transition layer 8-2 is 0.258eV, the thickness range of the second transition layer 8-2 is less than or equal to 9 microns, which is a fairly universal feature.

In the embodiment, the doping concentration range of the second transition layer 8-2 is larger than or equal to $2.4 \times 10^{14}$/cm$^3$ and less than or equal to $2.4 \times 10^{16}$/cm$^3$.

The doping concentration range of the second transition layer 8-2 can ensure the voltage withstand capability of the device.

In the embodiment, the doping concentrations of the drift region 7, the first transition layer 8-1, and the second transition layer 8-2 are increased sequentially.

The optimal performance is achieved, ensuring that the depletion region is completely stopped in the first transition layer 8-1 when the device operates, and the thickness of the second transition layer 8-2 is easy to design.

The IGBT device in which the first doping type is N-type doping and the second doping type is P-type doping will be described below.

The IGBT device according to the embodiment of the present disclosure achieves lower losses than conventional super junction IGBTs by optimizing the thicknesses of the first transition layer 8-1 and the second transition layer 8-2 and the thickness and concentration of the field-stop layer 9.

In order to obtain adaptable thicknesses of the first transition layer 8-1 and the second transition layer 8-2 and the thickness and concentration of the field-stop layer 9, the design process of the IGBT device according to the embodiment of the present disclosure is as follows:

For high-voltage and high-power super junction IGBT devices, the current trailing in the turn-off stage (in the turn-off stage, the actual current of the IGBT device is dropping) is the key to the performance of the device, which directly affects the value of the turn-off loss. The invention focuses on solving the trailing of the current in the turn-off stage of the Super Junction IGBT.

The IGBT device enters the current tailing stage, the first transition layer 8-1 to the collector direction, the conduction band (Ec), electron quasi-Fermi level ($E_{Fn}$), hole quasi-Fermi level ($E_{Fp}$) and valence band (Ev) energy level in the device increases rapidly, and a high carrier barrier appears inside the device, resulting in the carrier in the bottom region of the chip cannot freely enter the space electric field region, and most of the non-equilibrium carriers in this region can only disappear through recombination, resulting in a long-term tail current.

In order to more accurately design the thicknesses and concentrations of the first transition layer 8-1, the second transition layer 8-2, and the field-stop layer 9, the invention provides to speed up the design of the optimal SJ IGBT structure from the energy band perspective.

The design-fundamental IGBT device of the present disclosure is an IGBT device of which layer structure is consistent with the finished IGBT device of the present disclosure, and the thickness of the second transition layer 8-2 is relatively large (that is, the excess carriers of the second transition layer 8-2 are not precisely controlled) to have simulation and theoretical calculation.

Firstly, the turn-off stage of the superjunction design-fundamental IGBT device is analyzed according to band theory. In the turn-off stage, the actual current of the design-fundamental IGBT device continues to drop.

Step S1-1: Initially assigning value to the second predetermined current ratio of the design-fundamental IGBT device, such as the initial value assigned is 10%;

Step S2-1: Determining a time when the actual current dropped to the predetermined current ratio 10% of the rated current of the design-fundamental IGBT device, and the time divide the turn-off stage into a front turn-off stage and a rear turn-off stage; and

Step S3-1: Determining the ratio of the turn-off loss of the rear turn-off stage to the turn-off loss of the entire turn-off stage:

if the ratio is within the predetermined control range, the value assigned at this time is the value of the second predetermined current ratio of the rated current which the actual current of the design-fundamental IGBT device dropped to; and

if the ratio is not within the predetermined control range, re-jumping to step S1-1 until the assigned value as the second predetermined current ratio of the rated current which the actual current of the design-fundamental IGBT device dropped to is found.

In this way, the second predetermined current ratio of the design-fundamental IGBT device is assigned several times by simulation, and the method is continuously approaching until the value assigned as the second predetermined current ratio of the design-fundamental IGBT device is found. Thus, the first predetermined current ratio of the finished IGBT device is obtained.

At the moment when the actual current of the IGBT device drops to 10% of the rated current, the turn-off loss generated after this moment greatly increases the turn-off loss of the device (for example, the ratio of the turn-off loss in the rear turn-off stage to the turn-off loss in the entire turn-off stage reaches 30%, that is, the predetermined control range is larger than or equal to 20% and less than or equal to 50%), that is, 10% can be defined as the predetermined current ratio A% of the rated current of the IGBT device which the actual current of the IGBT device dropped to. At this time, the distribution of non-equilibrium carriers in the first transition layer 8-1, the second transition layer 8-2, and the field-stop layer 9 is shown in Fig. 3.

At present, in the turned-off stage of most IGBT devices, when the actual current drops to 10% of the rated current, the voltages at two terminals are already the bus voltage, and the depletion region has been formed. Therefore, the interface between the first transition layer 8-1 and the second transition layer 8-2 is formed, and the interface does not change subsequently. The present disclosure provides the technical concept of, in the turned-off stage of the IGBT device and after the depletion region has been formed, forming the first transition layer 8-1 and the second transition layer 8-2 and precisely controlling the excess carriers of the second transition layer 8-2, thereby reducing the tail current.

Fig. 3 is an energy band diagram inside the device in a case where the actual current drops to 10% of the rated current during the turn-off stage of the super junction IGBT device. The unit of the horizontal and vertical axes is eV, the black solid curve is $Ec-E_{Fn}$, and the black dashed curve is $E_{Fp} - Ev$.

As shown in Fig. 3, at the time when the actual current of the IGBT device drops to 10% of the rated current during the turn-off stage of the IGBT device, the device can be divided into four regions according to the energy band characteristics at different positions inside the device:

the super junction pillar region 6, the first transition layer 8-1 (depletion region), the second transition layer 8-2, and the field-stop layer 9.

When the actual current of the IGBT device drops to 10% of the rated current, the energy bands in the four regions are analyzed as follows:

The distance ($Ec-E_{Fn}$) from the conduction band (Ec) to the quasi-Fermi level ($E_{Fn}$) directly reflects the electron concentration at the corresponding position, and the electron concentration increases exponentially with the decrease of ($Ec-E_{Fn}$).

Correspondingly, the distance ($E_{Fp}-Ev$) from the valence band (Ev) to the quasi-Fermi level ($E_{Fp}$) directly reflects the hole concentration, and the hole concentration increases exponentially with the decrease of ($E_{Fn}-Ev$).

The super junction pillar region 6: since ($Ec-E_{Fn}$) is higher than 0.6eV (corresponding to $Ec-E_{Fn} > 0.6eV$), there are almost no electrons in this region.

Correspondingly, ($E_{Fp}-Ev$) is between 0.35eV and 0.4eV (corresponding to $0.35eV < E_{Fp}-E_v < 0.4eV$), so there is a certain amount of conductive holes in this region. The super junction pillar region 6 is a region where the drift region 7 coincides with the pillar region 6 of the second doping type. The above-mentioned band characteristics indicate that the conductive carriers in the super junction pillar region 6 are mainly holes. The holes in this region are mainly introduced by the drift of the space electric field in the first transition layer 8-1.

The first transition layer 8-1 (depletion region): (Ec-$E_{Fn}$) rapidly increases from 0.375eV and exceeds 0.6eV. Obviously, there are only a few electrons in this region at the critical position with the second transition layer 8-2, and there are no conductive electrons in the remaining positions.

The ($E_{Fp}$-Ev) characteristics of this region are similar to the super junction pillar region 6, and ($E_{Fp}$-Ev) is between 0.35eV and 0.4eV (corresponding to 0.35eV < $E_{Fp}$-$E_v$ < 0.4eV), then there is a certain amount of conductive holes in this region. That is, the first transition layer 8-1 also has a large number of holes, and a hole current is generated. The holes in this region are mainly introduced by the diffusion of the second transition region 8-2.

The second transition layer 8-2: Both (Ec-$E_{Fn}$) and ($E_{Fp}$-Ev) in this region are less than 0.375eV, indicating that there are conductive electrons and holes in this region at the same time, and form an on-current (manifested as a tail current during IGBT turning-off stage).

As the depth from the back of the chip increases, (Ec-$E_{Fn}$) shows a monotonous increasing trend, that is, the electron concentration decreases exponentially.

On the contrary, ($E_{Fp}$-Ev) shows a nonlinear trend of decreasing firstly and then increasing, that is, there is a hole-rich region in the middle of the region. The duration of IGBT tail current depends on the total number of holes in the hole-rich region. Obviously, optimizing the hole distribution morphology in this region can fundamentally improve the problem of IGBT current trailing.

The field-stop layer 9: Both (Ec-$E_{Fn}$) and ($E_{Fp}$-Ev) in this region are less than 0.375eV, indicating that there are conducting electrons and holes in this region at the same time, generating electron currents and hole currents respectively.

As the depth from the back of the chip increases, (Ec-$E_{Fn}$) shows a monotonous decreasing trend, that is, the electron concentration increases exponentially.

On the contrary, ($E_{Fp}$-Ev) shows a monotonic decreasing trend, that is, the hole concentration decreases exponentially. The above characteristics indicate that the hole concentration within the field-stop layer 9 decreases rapidly with increasing depth.

Thus, the non-equilibrium carriers in the first transition layer 8-1, the second transition layer 8-2, and the field-stop layer 9 are the fundamental problem of current tailing. In order to effectively reduce the tailing current, the device structure can be designed and optimized by controlling the total amount of non-equilibrium carriers to reduce the total amount of excess carriers. In the present disclosure, under the premise of maintaining the pressure-bearing capacity of the device, the thickness of the first transition layer 8-1 and the second transition layer 8-2 under the pillar region, the thickness and concentration of the field-stop layer 9 are designed to obtain the optimal turn-off characteristics, that is, small current trailing.

So far, the IGBT device whose thickness of the second transition layer 8-2 is relatively large (that is, the excess carriers of the second transition layer 8-2 are not precisely controlled) has a relatively large tail current. Therefore, it is necessary to control the excess carriers (i.e., holes) of the second transition layer 8-2. How to control and the method of control are important contents of the disclosure, as follows:

The total amount of non-equilibrium carriers (i.e. excess carriers) in the second transition layer 8-2 is theoretically analyzed, and the relationship between the thickness $H_2$ and the energy band of the second transition layer 8-2 is obtained.

The process is as follows:

Based on the theory of semiconductor physics, the carrier concentration per unit volume p and the energy band satisfy the following number order relationship:

$$p = n_i \times e^{\frac{E_i - E_F}{kT}}$$

Formula 1;

where Formula 1 is not only applicable to hole carriers, but also applicable to electron carriers; p is the carrier concentration per volume, $n_i$ is the intrinsic carrier concentration, e is the natural unit of charge, K is the Boltzmann constant (1.38×10-23J/K), T is the temperature, $E_i$ is the midline level of the band gap, and $E_F$ is the Fermi level. Intrinsic carrier concentration $n_i$ is the equilibrium concentration of free electrons and free holes in intrinsic semiconductor materials. The common value of $n_i$ is the concentration value at 300K. When T = 300K, the recognized value of the intrinsic carrier concentration $n_i$ of silicon is $1.5 \times 10^{10}$/cm$^3$.

Since it can be seen from Fig. 3 that there is a hole-rice region in the middle of the second transition layer 8-2, that is, the excess carriers of the second transition layer 8-2 should be holes. When the thickness of the second transition layer 8-2 is expressed by $H_2$, the concentration P of holes per unit volume of the second transition layer 8-2 satisfies Formula 2:

$$P = H_2 \times n_i \times e^{\frac{E_i - E_F}{kT}}$$

Formula 2.

In order to effectively control the number of excess carriers in the second transition layer 8-2, in the structure of the IGBT device design according to the embodiment of the present disclosure, the excess carriers in the second transition layer 8-2 are hole carriers, and the concentration P per unit volume of holes in the second transition layer 8-2 further satisfies Formula 3:

$$P \leq n_i$$

Formula 3.

The essence of Formula 3 is to control the number of holes in the second transition layer 8-2. Formula 3 is the first predetermined relationship.

Under the technical idea of precisely controlling the excess carriers of the second transition layer 8-2, the inventor did a large number of simulations. On the basis of a large number of simulations, combined with theoretical derivation, the first predetermined relationship is obtained. It is found that if the second transition layer 8-2 satisfies the first predetermined relationship, the tail current generated by excess carriers is small, which minimizes the turn-off loss. The simulation and measurement results are shown in Figs. 4 and 5.

For hole carriers, $(E_i - E_F)$ and the band gap satisfies Formula 4:

$$E_i - E_F = \frac{E_g}{2} - (E_{Fp} - E_V)$$

Formula 4;

where $E_g$ is the band gap of Si material and $E_g$ = 1.12 eV at ambient temperature (T = 300K), $E_{Fp}$ is the hole quasi-Fermi level, $E_{Fn}$ is electron quasi-Fermi level, Ev is the valence band level and here is the valence band energy level of silicon material.

$$H_2 \times n_i \times e^{\frac{\frac{E_g}{2} - (E_{Fp} - E_V)}{kT}} \leq n_i$$

Bring Formula 4 into Formula 3, can be obtained, further to simplify to obtain Formula 5:

$$H_2 \times e^{\frac{\frac{E_g}{2} - (E_{Fp} - E_V)}{kT}} \leq 1$$

Formula 5.

That is, the thickness $H_2$ of the second transition layer 8-2 is related to the energy band.

Further derivation, it is concluded that:

$$H_2 \leq 1 / e^{\frac{\frac{E_g}{2} - (E_{Fp} - E_V)}{kT}}$$

defined as the second predetermined relationship.

In the second predetermined relation, at ambient temperature (T = 300 K), $E_g$ = 1.12eV, the electron energy is expressed as kT to be 0.026eV, that is, kT = 0.026eV, and brought into the second predetermined relationship to obtain the third predetermined relationship;

$$H_2 \leq 1/e^{\frac{0.56 - (E_{Fp} - E_V)}{0.026}}$$

defined as the third predetermined relationship.

Thus, according to the theoretical analysis, a third predetermined relationship for the thickness $H_2$ of the second transition layer 8-2 is obtained.

So far, the third predetermined relationship shows the predetermined relation satisfied by the thickness and energy band of the second transition layer 8-2. The turn-off loss of the IGBT device according to the embodiment of the present disclosure (having the second transition layer 8-2 satisfying the third predetermined relationship) for the entire turn-off stage corresponds only to the (1 - predetermined control range B%) of turn-off loss of the entire turn-off stage of the design-fundamental IGBT device.

In the third predetermined relationship, the value of $E_{Fp}$ - $E_V$ at each thickness position of the second transition layer 8-2 is different, that is, the value of $E_{Fp}$-$E_V$ in the second transition region is variable.

Overall, the value $E_{Fp}$ - $E_V$ in the third predetermined relationship is the average value of $E_{Fp}$ - $E_V$ at each thickness position of the second transition layer 8-2.

Combining the above theoretical analysis with the simulation verification results, when the average value of $E_{Fp}$ - $E_V$ at each thickness position of the second transition layer 8-2 is 0.258eV, and 0.258eV is brought into the third predetermined relationship, and the value range of the second transition layer 8-2 is obtained to be less than or equal to 9 microns.

It is obtained by simulation that when the average value of $E_{Fp}$ - $E_V$ at each thickness position of the second transition layer 8-2 is 0.258eV, the excess holes of the second transition layer 8-2 do not cause a significant tail current.

The inventors did several simulations on the IGBT devices of the present disclosure of various powers, and when the average value of $E_{Fp}$ - $E_V$ at each thickness position of the second transition layer 8-2 is 0.258eV, the IGBT devices of various powers do not generate significant tail current. Therefore, for the IGBT device having the drift region 7, the pillar region 6, the first transition layer 8-1, and the second transition layer 8-2, when the average value of $E_{Fp}$ - $E_V$ at each thickness position of the second transition layer 8-2 is 0.258eV, the thickness range of the second transition layer 8-2 is less than or equal to 9 microns, which is a fairly universal feature.

The first transition layer 8-1 will be described below.

As the doping of the first transition layer 8-1 is evenly doped, the thickness $H_1$ of the first transition layer 8-1 ranges from larger than 0 microns and less than or equal to 2 microns.

In the embodiment, when the doping of the first transition layer 8-1 is evenly doped, under the condition that the thickness $H_1$ of the first transition layer 8-1 is ranged from larger than 0 microns and less than or equal to 2 microns, the following requirements need to be satisfied:

The doping concentration $N_D$ of the first transition layer 8-1 and the thickness $H_1$ of the first transition layer 8-1 satisfy the following relationship:

$$n\% \times k\% \times BV = Em \times H_1 - q \times N_D \times H_1^2/2\mathcal{E}s;$$

$$Em = k\% \times Ec;$$

where k% is the percentage of the electric field intensity to the critical breakdown electric field intensity under the condition of the minimum predetermined working voltage of the IGBT device, and the value of the percentage of the minimum predetermined working voltage to the breakdown voltage is the value of k%; n% is the percentage of the voltage bore by the first transition layer 8-1 to the minimum predetermined operating voltage, the value range of n% is larger than 0% but less than or equal to 5%, Em is the maximum field strength corresponding to the minimum predetermined operating voltage of the IGBT device, Ec is 0.25Mv/cm, q is the charge of a single electron, and $\varepsilon s$ is the dielectric constant of the Si substrate of the IGBT device.

The first transition layer 8-1 satisfies the above requirements. The interface between the first transition layer 8-1 and the second transition layer 8-2 is an interface where the IGBT device forms the depletion region during the turn-off stage. The depletion region is located in the first transition layer 8-1 and does not enter the second transition layer 8-2.

Specifically, when the value of n% is 5%, the value of k% is 10%, and the above formula corresponds to:

$$5\% \times 10\% \times BV = Em \times H_1 - q \times N_D \times H_1^2/2\mathcal{E}s;$$

$$Em = 10\% \times Ec;$$

where k% is the percentage of the electric field intensity to the critical breakdown electric field intensity under the condition of the minimum predetermined working voltage of the IGBT device, n% is the percentage of the voltage borne by the first transition layer 8-1 to the minimum predetermined working voltage, n% is larger than 0% but less than or equal to 5%, Em is the maximum field strength corresponding to the minimum predetermined working voltage of the IGBT device, Ec is 0.25Mv/cm, q is the charge amount of a single electron, and εs is the dielectric constant of Si.

5%×10%×BV on the left side of the formula, that is, the voltage value that the first transition layer 8-1 can withstand. For example, the breakdown voltage target of the IGBT device design is 1200 volts, and the minimum predetermined operating voltage is 10% × BV, that is, the super junction structure formed by the drift region and the pillar region undertakes 95% of the minimum predetermined operating voltage. Then, the first transition layer 8-1 bears 5% of the minimum predetermined operating voltage, and the actual voltage value borne by the first transition layer 8-1 varies with the thickness and the doping concentration of the first transition layer 8-1.

The field-stop layer 9 of the IGBT device is described below.

In the embodiment, the doping concentration of the field-stop layer 9 is less than the doping concentration of the first transition layer 8-1 and the second transition layer 8-2.

The thickness of the field-stop layer 9 is larger than or equal to 1 micron and less than or equal to 3 microns, and the doping concentration of the field-stop layer 9 is larger than or equal to $2\times10^{15}$/cm$^3$ and less than or equal to $2\times10^{17}$/cm$^3$.

In the embodiment, the doping concentrations of the drift region 7, the first transition layer 8-1, and the second transition layer 8-2 are increased sequentially.

While preferred embodiments of the present disclosure have been described, further verifications and modifications to these embodiments may be made by one skilled in the art once the underlying creative concepts are known to one skilled in the art. The appended claims are therefore intended to be construed to include preferred embodiments and all verifications and modifications falling within the scope of the present disclosure.

Obviously, one skilled in the art can make various modifications and variations to this application without departing from the spirit and scope of this application. Thus, to the extent that these modifications and variations of this application fall within the scope of the claims in this application and their equivalent techniques, this application is intended to include these modifications and variations as well.

**Claims**

1.    An IGBT device, **characterized in that**, comprising:

a drift region (7) of the first doping type;
a plurality pillar regions (6) of the second doping type, disposed at intervals in the lateral direction within the drift region (7); and
a transition layer of the first doping type, connected under the pillar region (6);
wherein the thickness of the transition layer is larger than 2 microns and less than or equal to 11 microns, and the doping concentration of the transition layer ranges from larger than or equal to $2.4\times10^{14}$/cm$^3$ to less than or equal to $2.4\times10^{16}$/cm$^3$.

2.    The IGBT device according to claim 1, wherein the transition layer comprises:

a first transition layer (8-1) connected under the pillar region (6), a thickness of the first transition layer (8-1) being ranged from larger than 0 microns and less than or equal to 2 microns, and a doping concentration of the first transition layer (8-1) being ranged from larger than or equal to $2.4\times10^{14}$/cm$^3$ to less than or equal to $2.4\times10^{16}$/cm$^3$; and
a second transition layer (8-2) connected under the first transition layer (8-1), a thickness of the second transition layer (8-2) being ranged from less than or equal to 9 microns, and a doping concentration of the second transition layer (8-2) being ranged from larger than or equal to $2.4\times10^{14}$/cm$^3$ to less than or equal to $2.4\times10^{16}$/cm$^3$.

3.    The IGBT device according to claim 2, wherein the doping concentrations of the drift region (7), the first transition layer (8-1), and the second transition layer (8-2) are increased in turn.

4.    The IGBT device according to claim 2, wherein the first transition layer (8-1) is evenly doped, and/or the second transition layer (8-2) is evenly doped.

5. The IGBT device according to any one of claims 1 to 4, further comprising:

a field-stop layer (9) of the first doping type, connected under the second transition layer (8-2);
wherein a doping concentration of the field-stop layer (9) is larger than the doping concentration of the first transition layer (8-1) and the second transition layer (8-2);
wherein a thickness of the field-stop layer (9) is ranged from larger than or equal to 1 micron and less than or equal to 3 microns, and the doping concentration of the field-stop layer (9) is ranged from larger than or equal to $2 \times 10^{15}/cm^3$ and less than or equal to $2 \times 10^{17}/cm^3$.

6. The IGBT device according to claim 5, further comprising:

a collector (10) of the second doping type, connected under the field-stop layer (9);
a deep groove formed downwardly from an upper surface of the drift region (7);
a gate oxide layer (5-2) formed on an inner bottom and side walls of the deep groove;
a gate electrode (5-1) formed in a space surrounded by the gate oxide layer (5-2);
a body region (4) formed on a surrounding of the gate oxide layer (5-2);
a first doping type region (3) formed on the body region (4);
an isolating oxide layer (2) formed over the first doping type region (3), a gate oxide layer (5-2), and a gate electrode (5-1); and
a metal emitter (1) formed on the isolating oxide layer (2);
wherein the first doping type is N-type doping, and the second doping type is P-type doping.

7. The IGBT device according to any one of claims 1 to 6, wherein a thickness and an energy band of the second transition layer (8-2) satisfy a predetermined relationship, so that excess carriers of the second transition layer (8-2) are precisely controlled to suppress a tail current generated by the second transition layer (8-2).

8. The IGBT device according to claim 7, wherein the second transition layer (8-2) satisfy the predetermined relationship:

in the turn-off stage of the IGBT device, when an actual current of the IGBT device drops to a first predetermined current ratio of the rated current of the IGBT device, the concentration P of holes per unit volume of the second transition layer (8-2) satisfies a first predetermined relationship:

$$P \leq n_i$$

defined as the first predetermined relationship;
wherein $n_i$ is the intrinsic carrier concentration of the silicon material and the first predetermined current ratio is ranged from larger than or equal to 10% and less than or equal to 20%.

9. The IGBT device according to claim 8, wherein the first predetermined current ratio of a finished IGBT device is equal to the second predetermined current ratio of a design-fundamental IGBT device;

wherein the finished IGBT device is an IGBT device in which excess carriers of the second transition layer (8-2) are precisely controlled, a structure of the design-fundamental IGBT device is same as the finished IGBT device, and excess carriers of the second transition layer (8-2) are not controlled;
wherein determining the second predetermined current ratio of the design-fundamental IGBT device is by a process of:

in a simulation process of the design-fundamental IGBT device, initially assigning value to the second predetermined current ratio;
determining a time when the actual current dropped to the assigned second predetermined current ratio of the rated current of the design-fundamental IGBT device, and the time divide the turn-off stage into a front turn-off stage and a rear turn-off stage; and
determining whether the ratio of the turn-off loss of the rear turn-off stage to the turn-off loss of the entire turn-off stage is within a predetermined control range:

if within the predetermined control range, the assigned value is the value of the second predetermined current ratio of the design-fundamental IGBT device;

if it is not within the predetermined control range, jumping to step of assigning until the assigned value as the second predetermined current ratio of the design-fundamental IGBT device is found.

10. The IGBT device according to claim 9, wherein the predetermined control range of the design-fundamental IGBT device is larger than or equal to 20% and less than or equal to 50%.

11. The IGBT device according to claim 8, wherein in the turn-off stage of the IGBT device, when the actual current of the IGBT device drops to a predetermined current ratio of the rated current of the IGBT device, the thickness $H_2$ and the energy band of the second transition layer (8-2) satisfy the following second predetermined relationship according to the first predetermined relationship:

$$H_2 \leq 1/e^{\frac{\frac{E_g}{2} - (E_{Fp} - E_V)}{kT}}$$

defined as the second predetermined relationship; wherein $H_2$ is the thickness of the second transition layer (8-2), e is a natural unit of charge and is a constant, k is a Boltzmann constant, T is a temperature, $E_g$ is a band gap width of the Si material and $E_g$ = 1.12 eV at ambient temperature, $E_{Fp}$ is a hole quasi-Fermi level and here a hole quasi-Fermi level of the silicon material, and Ev is a valence band level and here a valence band level of the silicon material.

12. The IGBT device according to claim 11, wherein kT = 0.026 eV and $E_g$ = 1.12 eV for T = 300 K, the second predetermined relationship is simplified to a third predetermined relationship:

$$H_2 \leq 1/e^{\frac{0.56 - (E_{Fp} - E_V)}{0.026}}$$

defined as the third predetermined relationship; wherein the value $E_{Fp} - E_V$ in the third predetermined relation is taken as an average value of $E_{Fp} - E_V$ at each thickness position of the second transition layer 8-2.

13. The IGBT device according to claim 12, wherein when the average value of $E_{Fp} - E_V$ at each thickness position of the second transition layer (8-2) is 0.258 eV, the second transition layer (8-2) is less than or equal to 9 microns.

14. The IGBT device according to any one claims 1 to 13, wherein, when the first transition layer (8-1) is evenly doped, the doping concentration $N_D$ of the first transition layer (8-1) and the thickness $H_1$ of the first transition layer (8-1) satisfy:

$$n\% \times k\% \times BV = Em \times H_1 - q \times N_D \times H_1^2/2\varepsilon s;$$

and

$$Em = k\% \times Ec;$$

wherein k% is the percentage of an electric field intensity to critical breakdown electric field intensity under a minimum predetermined working voltage of the IGBT device, and a percentage of the minimum predetermined working voltage to the breakdown voltage is the value of k%; n% is a percentage of voltage borne by the first transition layer (8-1) to the minimum predetermined operating voltage, n% is larger than 0% and less than or equal to 5%, Em is a maximum field corresponding to the minimum predetermined operating voltage of the IGBT device, Ec is 0.25 Mv/cm, q is the charge of a single electron, and εs is the dielectric constant of the Si substrate of the IGBT device.

15. An IGBT device, **characterized in that**, comprising:

a drift region (7) of a first doping type;
a plurality pillar regions (6) of a second doping type, disposed at intervals in the lateral direction within the drift region (7);

a first transition layer (8-1) of the first doping type, connected under the pillar region (6); and

a second transition layer (8-2) of the first doping type, connected under the first transition layer (8-1);

wherein an interface between the first transition layer (8-1) and the second transition layer (8-2) is an interface that forms a depletion region during the IGBT device turn-off stage;

wherein a thickness and an energy band of the second transition layer (8-2) satisfy a predetermined relationship, so that excess carriers of the second transition layer (8-2) are precisely controlled to suppress a tail current generated by the second transition layer (8-2).

Fig. 1

Fig. 2

Fig. 3

Fig. 4

In turn-off stage (junction temperature = 25 degrees Celsius, collector voltage = 400V, collector current = 75A real test of IGBT device)

Turn off (Tj=25 ℃ VCE=400V IC=75A) real test

Collector current (A) IC(A)

IC Curve

VCE Curve

Time of 2% rated current of conventional SJ IGBT

Time of 2% rated current of embodiment

Time of 90% rated current

Conventional SJ IGBT_VCE

Present embodiment SJ IGBT_VCE

Conventional SJ IGBT_IC

Present embodiment SJ IGBT_IC

time(s)

VCE(V) Collector voltage (V)

Fig. 5

25

Europäisches
Patentamt

European
Patent Office

Office européen
des brevets

# EUROPEAN SEARCH REPORT

**Application Number**

EP 24 18 9477

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2015/187869 A1 (PARK JAE HOON [KR] ET AL) 2 July 2015 (2015-07-02) * Fig. 3 and correlated text. * | 1-15 | INV. H10D12/00 H10D62/10 |
| Y | US 9 070 658 B2 (FUJI ELECTRIC CO LTD [JP]) 30 June 2015 (2015-06-30) * Fig. 13 and correlated text. * | 1-15 | |
| A | US 2019/109131 A1 (NAITO TATSUYA [JP]) 11 April 2019 (2019-04-11) * Figs. 2-4, 16-18 and correlated text. * | 1-15 | |
| A | US 2017/047408 A1 (KURIBAYASHI HIDENAO [JP] ET AL) 16 February 2017 (2017-02-16) * Figs. 8, 9 and correlated text. * | 1-15 | |
| A | WO 2018/164817 A1 (MAXPOWER SEMICONDUCTOR INC [US]) 13 September 2018 (2018-09-13) * Figs. 6, 7 and correlated text. * | 1-15 | |

**TECHNICAL FIELDS SEARCHED (IPC)**

H10D
H01L

The present search report has been drawn up for all claims

| Place of search | Date of completion of the search | Examiner |
|---|---|---|
| Munich | 20 December 2024 | Dauw, Xavier |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## EP 4 590 084 A1

### ANNEX TO THE EUROPEAN SEARCH REPORT
### ON EUROPEAN PATENT APPLICATION NO.

EP 24 18 9477

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2024

| Patent document cited in search report | Publication date | Patent family member(s) | Publication date |
|---|---|---|---|
| US 2015187869 A1 | 02-07-2015 | KR 20150076768 A | 07-07-2015 |
| | | US 2015187869 A1 | 02-07-2015 |
| US 9070658 B2 | 30-06-2015 | CN 102687277 A | 19-09-2012 |
| | | CN 104716174 A | 17-06-2015 |
| | | CN 105552115 A | 04-05-2016 |
| | | DE 112010004241 T5 | 08-05-2013 |
| | | JP 5569532 B2 | 13-08-2014 |
| | | JP 5900521 B2 | 06-04-2016 |
| | | JP 6264382 B2 | 24-01-2018 |
| | | JP 6515990 B2 | 22-05-2019 |
| | | JP 6844635 B2 | 17-03-2021 |
| | | JP 7147891 B2 | 05-10-2022 |
| | | JP 2014099643 A | 29-05-2014 |
| | | JP 2016076731 A | 12-05-2016 |
| | | JP 2018078314 A | 17-05-2018 |
| | | JP 2019106544 A | 27-06-2019 |
| | | JP 2021093541 A | 17-06-2021 |
| | | JP WO2011052787 A1 | 21-03-2013 |
| | | KR 20120104537 A | 21-09-2012 |
| | | US 2012267681 A1 | 25-10-2012 |
| | | US 2014284657 A1 | 25-09-2014 |
| | | US 2015303248 A1 | 22-10-2015 |
| | | US 2016111489 A1 | 21-04-2016 |
| | | US 2018350902 A1 | 06-12-2018 |
| | | US 2020219971 A1 | 09-07-2020 |
| | | US 2021091175 A1 | 25-03-2021 |
| | | WO 2011052787 A1 | 05-05-2011 |
| US 2019109131 A1 | 11-04-2019 | CN 109314141 A | 05-02-2019 |
| | | JP 6673502 B2 | 25-03-2020 |
| | | JP WO2018105744 A1 | 25-04-2019 |
| | | US 2019109131 A1 | 11-04-2019 |
| | | WO 2018105744 A1 | 14-06-2018 |
| US 2017047408 A1 | 16-02-2017 | CN 106463528 A | 22-02-2017 |
| | | JP 6269858 B2 | 31-01-2018 |
| | | JP WO2016080288 A1 | 27-04-2017 |
| | | US 2017047408 A1 | 16-02-2017 |
| | | WO 2016080288 A1 | 26-05-2016 |
| WO 2018164817 A1 | 13-09-2018 | US 2018261666 A1 | 13-09-2018 |
| | | WO 2018164817 A1 | 13-09-2018 |

EPO FORM P0459

For more details about this annex : see Official Journal of the European Patent Office, No. 12/82